(19) Europäisches Patentamt
European Patent Office
Office européen des brevets

(11) **EP 2 816 628 B1**

(12) **EUROPÄISCHE PATENTSCHRIFT**

(45) Veröffentlichungstag und Bekanntmachung des Hinweises auf die Patenterteilung:
**24.10.2018 Patentblatt 2018/43**

(51) Int Cl.:
***H01L 51/52*** *(2006.01)*

(21) Anmeldenummer: **14184883.8**

(22) Anmeldetag: **13.06.2008**

(54) **LICHTEMITTIERENDES ORGANISCHES BAUELEMENT UND ANORDNUNG MIT MEHREREN LICHTEMITTIERENDEN ORGANISCHEN BAUELEMENTEN**

LIGHT-EMITTING ORGANIC COMPONENT AND ARRANGEMENT HAVING A PLURALITY OF LIGHT-EMITTING ORGANIC COMPONENTS

COMPOSANT ORGANIQUE LUMINESCENT ET AGENCEMENT AVEC PLUSIEURS COMPOSANTS ORGANIQUES LUMINESCENTS

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **15.04.2008 DE 102008019049**

(43) Veröffentlichungstag der Anmeldung:
**24.12.2014 Patentblatt 2014/52**

(62) Dokumentnummer(n) der früheren Anmeldung(en) nach Art. 76 EPÜ:
**08784193.8 / 2 272 116**

(73) Patentinhaber: **Novaled GmbH**
**01307 Dresden (DE)**

(72) Erfinder:
• **Birnstock, Jan**
**01307 Dresden (DE)**
• **Murano, Sven**
**01307 Dresden (DE)**
• **Langguth, Oliver**
**01307 Dresden (DE)**

(74) Vertreter: **Bittner, Thomas L.**
**Boehmert & Boehmert**
**Anwaltspartnerschaft mbB**
**Pettenkoferstrasse 22**
**80336 München (DE)**

(56) Entgegenhaltungen:
**EP-A- 1 003 229          EP-A- 1 549 110**
**WO-A-2008/040323      DE-A1-102006 013 408**
**JP-A- H11 354 279       JP-A- 2005 294 066**
**US-A1- 2006 209 225**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein lichtemittierendes organisches Bauelement und eine Anordnung mit mehreren lichtemittierenden organischen Bauelementen.

Hintergrund der Erfindung

Lichtemittierende organische Bauelemente in Form organischer Leuchtdioden (OLEDs), welche farbiges Licht, insbesondere Weißlicht emittieren, haben in den vergangenen Jahren verstärkte Aufmerksamkeit gewonnen. Es ist allgemein anerkannt, dass die Technologie organischer Leuchtbauelemente ein großes Potenzial für mögliche Anwendungen im Bereich der Beleuchtungstechnik besitzt. Mittlerweile erreichen organische Leuchtdioden Leistungseffizienzen, welche im Bereich von konventionellen elektrischen Glühbirnen liegen (vgl. Forrest et al., Adv. Mat. 7(2004)624).

Organische Leuchtdioden werden üblicherweise mit Hilfe eines Schichtaufbaus gebildet, der auf einem Substrat angeordnet wird. In dem Schichtaufbau ist zwischen einer Elektrode und einer Gegenelektrode eine organische Schichtanordnung angeordnet, sodass die organische Schichtanordnung über die Elektrode und die Gegenelektrode mit einer elektrischen Spannung beaufschlagt werden kann. Die organische Schichtanordnung ist aus organischen Materialien hergestellt und umfasst einen lichtemittierenden Bereich. In dem lichtemittierenden Bereich rekombinieren Ladungsträger, nämlich Elektronen und Löcher, die beim Anlegen der elektrischen Spannung an die Elektrode und die Gegenelektrode in die organische Schichtanordnung injiziert und dort zu dem lichtemittierenden Bereich transportiert werden. Eine wesentliche Effizienzsteigerung bei der Lichterzeugung konnte erreicht werden, indem in die organische Schichtanordnung elektrisch dotierte Schichten integriert wurden.

Organische Leuchtbauelemente können in verschiedensten Anwendungsbereichen genutzt werden, um Licht beliebiger Farbe zu erzeugen, wozu insbesondere Anzeigeeinrichtungen, Beleuchtungseinrichtungen und Signaleinrichtungen gehören.

In einer Ausführungsform können die organischen Leuchtbauelemente so gestaltet werden, dass sie Weißlicht abgeben. Derartige Bauelemente haben das Potenzial, eine bedeutende Alternative zu den momentan am Markt dominierenden Beleuchtungstechnologien darzustellen, beispielsweise Glühlampen, Halogenlampen, Niederspannungsleuchtstoffröhren oder dergleichen.

Trotzdem sind für eine erfolgreiche Kommerzialisierung der Technologie der organischen Leuchtbauelemente noch wesentliche technische Probleme zu lösen. Insbesondere ist es eine Herausforderung, mittels OLED-Bauelementen große Lichtmengen zu erzeugen, welche für allgemeine Beleuchtungsanwendungen benötigt werden. Die von einem OLED-Bauelement abgegebene Lichtmenge wird durch zwei Faktoren bestimmt. Dieses sind die Helligkeit im Bereich der Leuchtfläche des Bauelementes und die Größe der Leuchtfläche. Die Helligkeit eines organischen Leuchtbauelementes lässt sich nicht beliebig steigern. Darüber hinaus wird auch die Lebensdauer organischer Bauelemente wesentlich von der Helligkeit beeinflusst. Wird beispielsweise die Helligkeit eines OLED-Bauelementes verdoppelt, so reduziert sich dessen Lebensdauer um den Faktor zwei bis vier. Als Lebensdauer ist hierbei die Zeit definiert, die vergeht, bis das OLED-Bauelement beim Betrieb mit einem konstanten Strom auf seine halbe Ausgangshelligkeit abgefallen ist.

Die Leuchtfläche eines OLED-Bauelementes für Beleuchtungsanwendungen muss entsprechend einer gewünschten abgegebenen Lichtmenge gewählt werden. Es ist anzustreben, dass sie im Bereich von einigen Quadratzentimetern bis hin zu einer Größe von über einem Quadratmeter liegt.

OLED-Bauelemente werden als elektrisches Bauelement typischerweise bei niedrigen Spannung im Bereich von etwa 2V bis etwa 20V betrieben. Der durch das OLED-Bauelement fließende Strom wird durch die Leuchtfläche bestimmt. Schon bei einer relativ kleinen Leuchtfläche des OLED-Bauelementes von etwa 100cm$^2$ würde bei einer angenommenen Stromeffizienz von 50cd/A und einer Anwendungshelligkeit von 5000cd/m$^2$ ein Strom von 1A benötigt.

Ein organisches Leuchtbauelement mit einem solchen Strom zu versorgen, stellt jedoch ein erhebliches technisches Problem dar und lässt sich in kommerziellen Beleuchtungsanwendungen nicht ohne weiteres auf preiswerte Art und Weise lösen. Bekanntermaßen ist die elektrische Verlustleistung der Stromzuführung proportional zum elektrischen Widerstand der Zuleitung und zum Quadrat des fließenden Stromes. Um also die Verlustleitung auch bei großen Strömen gering zu halten, müssten elektrische Zuleitungen mit einem sehr niedrigen Widerstand, also einem großen Querschnitt genutzt werden. Gerade dieses ist aber bei einem Bauelement zu vermeiden, dessen herausragende Eigenschaft unter anderem die flache Bauweise ist. Sofern größere Bauteilflächen benötigt werden, müsste der Versorgungsstrom weiter gesteigert werden, wodurch sich die Probleme bei der Stromversorgung weiter verschärfen würden.

Aus diesem Grund wurde vorgeschlagen, mehrere OLED-Elemente in einem organischen Leuchtbauelement elektrisch in Reihe zu schalten (vgl. GB 2 392 023 A). Hierbei wird die Gesamtfläche des organischen Leuchtbauelementes in einzelne OLED-Bauelemente aufgeteilt, welche in einer oder mehreren Reihenschaltungen elektrisch miteinander verknüpft sind. Auf diese Weise wird die Betriebsspannung des Leuchtbauelements etwa um einen Faktor erhöht, welcher der Anzahl der in Reihe geschalteten OLED-Bauelemente entspricht, wobei der fließende Strom um den gleichen Faktor verringert wird. Durch die Verringerung des Betriebsstromes bei gleichzeitiger Erhöhung der Betriebsspannung kann so bei gleicher Leistung eine deutliche Vereinfachung der Ansteuerung des Leuchtbauelementes erzielt werden, da es im Allgemeinen deutlich leichter ist, anstelle eines hohen Stromes eine hohe Spannung an ein elektrisches Bauelement heranzuführen. Ein weiter Vorteil, der sich aus der Nutzung der Reihenschaltung von OLED-Bauelementen ergibt, besteht darin, dass im Falle eines Kurzschlusses zwischen den beiden Elektroden, nämlich der Kathode und der Anode, eines der OLED-Bauelemente zwar ein Teil der Leuchtfläche des organischen Leuchtbauelementes ausfällt, insgesamt aber das Leuchtbauelement weiterhin Licht emittiert und die insgesamt emittierte Lichtmenge sogar aufgrund der nun für die verbleibenden nicht ausgefallenen OLED-Bauelemente erhöhten Betriebsspannung weitgehend unverändert bleibt. Somit kann ein solches Leuchtbauelement mit einer Reihenschaltung von OLED-Bauelementen auch nach einem Kurzschluss eines der OLED-Bauelemente weiterhin genutzt werden. Im Gegensatz dazu ist ein organisches Leuchtbauelement, welches über lediglich ein einzelnes OLED-Bauelement verfügt, bei einem Kurzschluss zwischen Anode und Kathode unbrauchbar.

Für die Herstellung von OLED-Leuchtbauelemente mit einer Reihenschaltung von OLED-Bauelementen ist jedoch ein komplexes Herstellungsverfahren notwendig. Zum einen ist es erforderlich, die Elektrode, welche auf dem tragenden Substrat gebildet wird, zu strukturieren, um die den einzelnen in Reihe geschalteten OLED-Bauelementen zugeordneten Elektroden zu definieren. Darüber hinaus ist es notwendig, die organischen Schichtanordnungen der einzelnen OLED-Bauelemente und die hierauf gebildete Deckelektrode zu strukturieren. Hierfür kommen verschiedene bekannte Verfahren in Betracht.

Im Fall von OLEDs, bei denen organische Materialien verwendet werden, die durch Vakuumverdampfungen aufgebracht werden können, ist ein geeignetes Verfahren zum Strukturieren das Aufdampfen mittel Schattenmasken. Weitere Verfahren sind beispielsweise das Aufbringen mittels LITI (*"Laser Induced Thermal Imaging"*), bei dem von einem Trägerfilm, welcher mit organischem Material beladen ist, zumindest ein Teil des organischen Materials auf das Substrat übertragen wird, in dem der Trägerfilm punktgenau mittels Laser erhitzt wird. Das LITI-Verfahren kann jedoch nur für die Strukturierung der organischen Schichtanordnung der OLED-Bauelemente verwendet werden. Zum Strukturieren der Deckelektrode, die ihrerseits üblicherweise aus Metallen wie Silber, Aluminium oder Magnesium oder einem leitfähigen transparenten Oxid wie Indium-Zinn-Oxid (ITO) besteht, muss ein anderes Strukturierungsverfahren herangezogen werden.

Die Strukturierungsverfahren haben einen erheblichen Aufwand im Rahmen der Herstellung des organischen Leuchtbauelementes zur Folge, wodurch hohe Kosten entstehen. Für den Fall der Verwendung von Schattenmasken besteht darüber hinaus das Problem einer begrenzten Auflösung, das heißt der Abstand zwischen den einzelnen in Reihe geschalteten OLED-Bauelementen ist durch die Abmessungen der Stege der Schattenmaske begrenzt. Hierbei ist zu beachten, dass in Abhängigkeit von der Größe der Aussparungen zwischen den Stegen der Schattenmaske eine gewisse Stegbreite der Schattenmaske erforderlich ist, um die mechanische Stabilität der Schattenmaske zu gewährleisten.

Um also die Strukturierung mittels Schattenmasken zu vereinfachen, ist es sinnvoll, auf eine Feinauflösung der mittels Schattenmaske strukturierten Bereiche zu verzichten. Dies kann dadurch geschehen, dass die in Reihe geschalteten OLED-Bauelemente relativ groß gestaltet werden, beispielsweise mit einer Größe von etwa 1cm$^2$. Hierdurch wird es ermöglicht, Schattenmasken mit einer geringen Präzision zu verwenden, welche sich mittels einfacher Verfahren ausrichten lassen, beispielsweise mittels Ausrichten unter Verwendung von Haltestiften. Solche Verfahren sind in der Massenproduktion deutlich günstiger als Methoden zur Feinjustierung, die beispielsweise auf der Ausrichtung mittels Positioniermarken unter einem Mikroskop basieren.

Weiterhin ist die Verwendung von Schattenmasken ein limitierender Faktor hinsichtlich der erreichbaren Prozessierungszeiten, da eine Feinjustierung der Schattenmasken einen nicht vernachlässigbaren Anteil an der Gesamtprozessdauer hat. Mittels Verwenden eines weniger genauen Verfahrens lassen sich die mit der Positionierung verbundenen Prozesszeiten verringern.

Für bestimmte Verfahren zum Herstellen von organischen Leuchtbauelementen, beispielsweise die kontinuierliche Rolle-zu-Rolle Methode, ergeben sich bei der bekannten Nutzung von Schattenmasken weitere Probleme. Zum einem muss in einem solchen Verfahren die Schattenmaske mit dem Substrat, auf dem der Schichtstapel mit den Elektroden und der organischen Schichtanordnung zu bilden ist, mitgeführt werden, ohne das die Position der Schattenmaske relativ zum Substrat geändert wird. Zum anderen muss in einem solchen Verfahren die Schattenmaske zum Substrat ausgerichtet werden, wobei im Rolle-zu-Rolle Verfahren das Substrat gegebenenfalls angehalten werden muss. Somit ist es wünschenswert, einen Prozess zur Verfügung zu haben, bei dem die Verwendung von hochauflösenden Schattenmasken nicht notwendig ist.

Die Nutzung von weniger genauen Schattenmasken führt nicht wirklich zu einer Optimierung, da sie mit erheblichen Nachteilen verbunden ist. Hierbei können lediglich größere OLED-Teilflächen gebildet werden. Sofern eine dieser Teilflächen durch einen Kurzschluss ausfällt, wird ein großer Teil der Leuchtfläche des Bauelementes inaktiv, das heißt sie bleibt dunkel beim Betrieb des Leuchtbauelementes. Hierdurch wird jedoch das Gesamtbauelement in seiner Funktionalität wesentlich beeinträchtigt. Zwar fällt in einer Reihenschaltung über dem kurzgeschlossenen OLED-Bauelement wenig Spannung ab, wodurch sich die Spannung für die anderen OLED-Bauelemente erhöht, weswegen dann insgesamt das ausgesendete Licht nur wenig verändert wird, jedoch ist der visuelle Eindruck des organischen Leuchtbauelementes wesentlich verschlechtert. Dieses ist für Anwendungszwecke nicht akzeptabel. Das Leuchtbauelement wird vom Betrachter als schadhaft wahrgenommen. Darüber hinaus führen elektrische Kurzschlüsse in OLED-Bauelementen dazu, dass nahezu der gesamte Strom, welcher normalerweise über die Gesamtfläche verteilt fließt, nur durch die Kurzschlussstelle geleitet wird. Hierdurch kommt es lokal zu einer starken Erwärmung, wodurch Ohm'sche Verluste entstehen und die Gefahr besteht, dass sich an der Kurzschlussstelle der Widerstand deutlich erhöht und somit die Kurzschlussstelle isolierend wird, beispielsweise aufgrund einer Delamination organischer oder anorganischer Schichten. Es droht die Gefahr, dass die zum Schutz des Leuchtbauelementes aufgebrachte Verkapselung diesem lokalen thermischen Stress nicht standhält, insbesondere bei Verwendung einer Dünnschichtverkapselung, wie sie heutzutage für OLED-Beleuchtungselemente der Zukunft angedacht ist. Diese nachteiligen Effekte werden umso größer je größer die Fläche des OLED-Bauelementes ist.

Neben der Effizienz und der Lebensdauer lichtemittierender organischer Bauelemente ist natürlich vor allem das Aussehen des Bauelements entscheidend für den kommerziellen Erfolg. Es liegt in der Natur der OLED, dass die Lichtabstrahlung auf größeren Flächen nicht völlig homogen ist, da vor allem die transparente Elektrode eine vergleichsweise geringe Leitfähigkeit typischerweise zwischen 1 Ohm/sq und 300Ohm/sq aufweist. Das bedeutet, aufgrund des durch die OLED fließenden Stroms gibt es einen Spannungsabfall über der transparenten Elektrode, der dazu führt, dass bestimmte Bereich der OLED dunkler leuchten als andere. Besonders markant ist dieses Problem bei OLEDs mit besonders steilen Strom-Spannungs-Kennlinien. Dies trifft insbesondere auf OLEDs vom pin-Typ zu, die aufgrund ihrer hohen Leistungseffizienz als besonders geeignet für Beleuchtungsanwendungen gelten. Verschiedene Vorschläge wurden gemacht, um die Homogenität der OLED zu verbessern. Weit verbreitet sind so genannte Metallgitter, also dünne Metalllinien, die mit der transparenten Elektrode in Kontakt stehen und einen Großteil des Stromtransports übernehmen (z.B. DE102006013408 A1). Diese Lösung ist technisch aufwendig, da sie mit mehreren Beschichtungs- und Photolithographieschritten verbunden ist.

Das Dokument US 2006/0209225 A1 offenbart eine Beleuchtungseinrichtung mit einer ersten lichttransmittierenden Elektrodenschicht und einer zweiten lichttransmittierenden Elektrodenschicht zwischen denen eine lumineszierende Schicht angeordnet ist. Wenigstens eine der ersten und zweiten lichttransmittierenden Elektrodenschichten umfasst ein ersten leitfähigen Teil und einen zweiten leitfähigen Teil. Der erste leitfähige Teil und der zweite leitfähige Teil sind mit unterschiedlichen Layout-Mustern gebildet.

Das Dokument WO 2008/040323 A2 offenbart ein organisches Leuchtmittel und eine Beleuchtungseinrichtung mit einem Leuchtmittel.

## Zusammenfassung der Erfindung

Aufgabe der Erfindung ist es, ein lichtemittierendes organisches Bauelement und eine Anordnung mit einer Reihenschaltung von mehreren lichtemittierenden organischen Bauelementen zu schaffen, mit denen die Bauelementzuverlässigkeit verbessert ist, insbesondere auch beim Auftreten von Kurzschlüssen. Bei den organischen lichtemittierenden Bauelementen sollen darüber hinaus die Leuchteigenschaften verbessert werden.

Diese Aufgabe wird durch ein lichtemittierendes organisches Bauelement nach dem unabhängigen Anspruch 1 sowie eine Anordnung mit einer Reihenschaltung von mehreren lichtemittierenden organischen Bauelementen nach dem unabhängigen Anspruch 11 gelöst. Weitere Ausgestaltungen der Erfindung sind Gegenstand von abhängigen Unteransprüchen.

Die Erfindung umfasst in Verbindung mit dem Bauelement den Gedanken, in dem lichtemittierenden organischen Bauelement eine der von dem zugehörigen Elektrodenpaar umfassten Elektroden mittels mehrerer untereinander elektrisch kurzgeschlossener Kammteilelektroden zu bilden, was bedeutet, dass die so gebildete Elektrode aus den Kammteilelektroden besteht. Bei den Kammteilelektroden greifen von einem jeweiligen Kammelektrodenverbindungsabschnitt vorstehende Kammelektrodenabschnitte wenigstens in einem Überlappungsbereich mit dem organischen Bereich ineinander. Das Ineinandergreifen kann in einer bevorzugten Ausgestaltung derart ausgeführt sein, dass vorstehende Kammelektrodenabschnitte voneinander gegenüberliegenden Kammteilelektroden abwechselnd angeordnet sind. Die an einem Kammelektrodenverbindungsabschnitt gebildeten vorstehenden Kammelektrodenabschnitte sind mit Hilfe des Kammelektrodenverbindungsabschnitts, welcher eine Art Anschluss für die vorstehenden Kammelektrodenabschnitte bildet, elektrisch kurzgeschlossen. Mehrere in der vorgenannten Art ausgeführte Bauelemente können in eine Reihenschaltung aufgenommen werden.

Die kammartige Ausbildung der Elektrode mit den Kammteilelektroden, sei es beim separaten Erzeugen der Elektrodenstruktur oder im Prozess einer Bauelementherstellung, kann beim Herstellen beispielsweise mittels Photolithographie erzeugt werden. Eine solche Feinstrukturierung ist problemlos und ohne zusätzliche Kosten möglich und erfordert keinen zusätzlichen Aufwand. Der Abstand der ineinandergreifenden vorstehenden Kammelektrodenabschnitte kann auf diese Weise sehr gering gehalten werden. Mittels der ineinandergreifenden vorstehenden Kammelektrodenabschnitte entsteht aus Sicht des Betrachters beim Betrieb des lichtemittierenden organischen Bauelementes eine homogene Leuchterscheinung.

Bei der Herstellung des Bauelementes oder der Anordnung von Bauelementen kann eine einfache Schattenmaskentechnik für die Ausbildung des organischen Bereiches und einer Deckelektrode genutzt werden, an die keine besonderen Anforderungen hinsichtlich der Positioniergenauigkeit zu stellen sind.

Ein weiterer Vorteil besteht darin, dass das vorgeschlagene lichtemittierende organische Bauelement ein besseres Ausfallverhalten beim Auftreten von Kurzschlüssen in dem Elektrodenbereich aufweist. Auch wenn einzelne vorstehende Kammelektrodenabschnitte aufgrund eines Kurzschlusses ausfallen, ergibt sich für den Betrachter im Betrieb immer noch ein im Wesentlichen homogenes Leuchtfeld. Hierbei ist der Erhalt der Leistungseffizienz des Bauelementes umso besser je weiter der Ort eines auftretenden Kurzschlusses im Bereich eines vorstehenden Kammelektrodenabschnitts von dem zugeordneten Kammelektrodenverbindungsabschnitt entfernt ist. Überhaupt führt ein Kurzschluss im Bereich eines vorstehenden Kammelektrodenabschnitts nicht zum Totalausfall des lichtemittierenden organischen Bauelementes. Er bleibt vielmehr auf den Bereich des betroffenen vorstehenden Kammelektrodenabschnitts beschränkt. Zur Ausbildung der vorstehend beschriebenen Vorteile trägt die vorgeschlagene Elektrodenstruktur als solche bei.

In einem zweckmäßigen Ausführungsbeispiel, bei dem ITO als Material für die Elektrode aus den Kammteilelektroden genutzt wird, ergibt sich dieses Verhalten dadurch, dass ITO einen vergleichsweise hohen Schichtwiderstand hat, woraus sich bei hohem Aspektverhältnis für die vorstehenden Kammelektrodenabschnitten, zum Beispiel ein Aspektverhältnis von 10:1, auch ein hoher Widerstand der ITO-Abschnitte ergibt. Da im normalen Betrieb des Bauelementes, in welchem die vorgeschlagenen Elektrodenstruktur dann eingesetzt werden kann, aufgrund der Parallelschaltung der vielen vorstehenden Kammelektrodenabschnitte jedoch nur ein sehr kleiner Strom über die einzelnen Abschnitte fließt, bleibt die Effizienz des Bauteils hoch. Erst im Moment des Kurzschlusses zwischen Elektrode und Gegenelektrode ergibt sich ein lokal höherer Strom, welcher jedoch durch den großen Widerstand in den vorstehenden Kammelektrodenabschnitten begrenzt ist. Im Fall eines Kurzschlusses wird also nur auf der Fläche des betroffenen vorstehenden Kammelektrodenabschnitts aus ITO kein Licht mehr emittiert. Die restliche Fläche des Bauelementes wird mit nahezu unveränderter Helligkeit weiter leuchten. Werden die zum Beispiel aus ITO gebildeten vorstehenden Kammelektrodenabschnitte dünn genug ausgeführt, zum Beispiel mit einer Breite zwischen etwa 10 μm und einigen Millimetern, wird der Betrachter den Kurzschluss überhaupt nicht bemerken.

Mit der Erfindung wird also einerseits die Möglichkeit geschaffen, die Leistungseffizienz des lichtemittierenden organischen Bauelementes auch im Fall eines lokalen Kurzschlusses hoch zu halten. Darüber hinaus bleibt die optische Erscheinung des Bauelementes mit der vorgeschlagenen Elektrodenstruktur im Betrieb auch bei lokalem Kurzschluss für den Betrachter im Wesentlichen ungestört.

Eine bevorzugte Weiterbildung der Erfindung sieht vor, dass die vorstehenden Kammelektrodenabschnitte formkomplementär ineinandergreifend angeordnet sind. Formkomplementär sind hierbei üblicherweise die Grundflächenformen der ineinandergreifenden vorstehenden Kammelektrodenabschnitte, so dass eine möglichst große Überlappung zwischen der Elektrode und dem organischen Bereich erreichbar ist.

Allgemein sind derartige Grundflächenformen also durch eine sich in einer Richtung verjüngende Form gekennzeichnet, wobei je nach Ausführungsform die Verjüngung der Grundflächenform der vorstehenden Kammelektrodenabschnitte entweder ausgehend von dem zugeordneten Kammelektrodenverbindungsabschnitt oder auf diesen zu erfolgt. In einer Ausgestaltung kann vorgesehen sein, dass die sich verjüngende Form an dem vorstehenden Kammelektrodenabschnitt erst in einem Abstand zu dem Kammelektrodenverbindungsabschnitt beginnt, so dass zwischen dem sich verjüngenden Kammelektrodenabschnitt und dem zugeordneten Kammelektrodenverbindungsabschnitt ein Zuführabschnitt mit im Wesentlichen parallelen Kanten gebildet ist. Hierbei kann vorgesehen sein, dass der Überlappungsbereich an dem Übergang zwischen dem Zuführabschnitt und dem Verjüngungsabschnitt der vorstehenden Kammelektrodenabschnitte beginnt.

Bevorzugt sieht eine Fortbildung der Erfindung vor, dass die vorstehenden Kammelektrodenabschnitte mit einer einheitlichen Grundflächenform gebildet sind. Es kann vorgesehen sein, dass die Kammteilelektroden hinsichtlich ihrer Grundflächenform insgesamt alle gleich gebildet sind. Es kann aber auch vorgesehen sein, dass die Kammteilelektroden ganz oder teilweise unterschiedlich hinsichtlich ihrer Grundflächenform ausgeführt sind, beispielsweise um eine individuelle Anpassung an unterschiedliche lichtemittierende organische Bauelemente zu erreichen.

Bei einer vorteilhaften Ausgestaltung der Erfindung kann vorgesehen sein, dass die vorstehenden Kammelektrodenabschnitte mittels des jeweiligen Kammelektrodenverbindungsabschnitts außerhalb des organischen Bereiches untereinander elektrisch kurzgeschlossen sind.

Eine Weiterbildung der Erfindung kann vorsehen, dass die Gegenelektrode innerhalb der flächigen Ausdehnung des organischen Bereiches und mit einer im Vergleich hierzu kleineren Flächenausdehnung gebildet ist.

Eine bevorzugte Weiterbildung der Erfindung sieht vor, dass ein zu dem jeweiligen Kammelektrodenverbindungsabschnitt distales Ende der vorstehenden Kammelektrodenabschnitte mit einem Rand des organischen Bereiches abschließt. Diese bedeutet mit anderen Worten, dass der vorstehende Kammelektrodenabschnitt im Bereich des distalen Endes nicht über den organischen Bereich übersteht.

Eine vorteilhafte Ausführungsform der Erfindung sieht vor, dass die von den Kammteilelektroden gebildete Elektrode eine substratseitige Elektrode ist. Alternativ zur substratseitigen Elektrode, die auch als Grundelektrode bezeichnet wird, kann die Top- oder Deckelektrode mit den Kammteilelektroden gebildet sein. Bevorzugt sieht eine Fortbildung der Erfindung vor, dass in einem Eingriffsbereich ein seitlicher Abstand zwischen benachbarten der vorstehenden Kammelektrodenabschnitte weniger als etwa $10\mu m$ beträgt. Hierdurch ist erreicht, dass mit bloßem Auge das Vorhandensein von nicht leuchtenden Bereichen zwischen den vorstehenden Kammelektrodenabschnitten nicht mehr auflösbar sind.

Bei einer vorteilhaften Ausgestaltung der Erfindung kann vorgesehen sein, dass ein wenigstens mit dem organischen Bereich flächig überlappendes Streuelement gebildet ist. Das Streuelement kann beispielsweise als eine Streuscheibe oder eine Streufolie ausgeführt sein. Nicht nur im normalen Betrieb des Bauelementes sondern insbesondere auch beim teilweisen Ausfall von Teilen des Bauelementes infolge eines Kurzschlusses trägt das flächig überlappende Streuelement zu einer verbesserten Leuchterscheinung des Bauelementes für den Betrachter bei.

Eine Weiterbildung der Erfindung kann vorsehen, dass den vorstehenden Kammelektrodenabschnitten der Kammteilelektroden jeweils eine elektrische Sicherungsstruktur zugeordnet ist. Die elektrische Sicherungsstruktur, bei der es sich beispielsweise um eine Schmelzsicherung handelt, kann mehrere Einzelsicherungsstrukturen, die jeweils einem der vorstehenden Kammelektrodenabschnitte zugeordnet sind, oder eine für mehrere vorstehende Kammelektrodenabschnitte gemeinsam gebildete Sicherungsstruktur umfassen. Die jeweilige Sicherungsstruktur ist in ihrem Design ausgelegt, beim Auftreten eines erhöhten Betriebsstromes eine elektrische Isolierung selbstständig auszulösen. Auf diese Weise werden betroffene Abschnitte der Elektrode von anderen Abschnitten getrennt, wenn ein Kurzschluss auftritt, so dass verbleibende Abschnitte des Bauelementes weiter betrieben werden können.

Bei einer vorteilhaften Ausgestaltung der Erfindung kann vorgesehen sein, dass die elektrische Sicherungsstruktur eine Schicht aus organischem Material aufweist. Die organische Schicht kann elektrisch dotierte Schicht sein. Die Ausführung erfolgt als p-dotierte oder n-dotierte Halbleiterschicht. Die elektrische Sicherungsstruktur kann vollständig oder teilweise mit der elektrisch dotierten Schicht gebildet sein. In einer bevorzugten Ausgestaltung ist die elektrisch dotierte Schicht in ihrer Materialzusammensetzung gleich einer der Schichten aus dem organischen Bereich gebildet, was den Vorteil hat, dass die elektrisch dotierte Schicht der Sicherungsstruktur gleichzeitig mit der in gleicher Weise ausgeführten Schicht in dem organischen Bereich bei der Herstellung geschaffen werden kann, sofern dieses in den Produktionsprozess zweckmäßig integriert werden kann. Die elektrisch dotierte Schicht ist vorzugsweise mit einer Schichtdicke zwischen etwa 10 nm und etwa 100 $\mu m$ gebildet. Eine Schichtdicke von etwa 10 nm wird als eine Dicke angesehen, die mindestens benötigt wird, um mit üblichen Fertigungsanlagen sicher eine geschlossene organische Schicht zu bilden. 100 $\mu m$ ist eine Schichtdicke, die noch in einem angemessenen prozesstechnischen Rahmen realisiert werden kann.

Alternativ oder in Ergänzung zu der Ausbildung der elektrisch dotierten Schicht kann in einer Ausgestaltung der Sicherungsstruktur eine Schicht aus organischem Material vorgesehen sein, die nicht elektrisch dotiert ist. Hinsichtlich der Schichtdicke der nicht dotierten organischen Schicht gelten die vorangehenden Ausführungen zur dotierten organischen Schicht entsprechend.

Eine Weiterbildung der Erfindung kann vorsehen, dass die elektrische Sicherungsstruktur eine Metallschicht aufweist. Die elektrische Sicherungsstruktur kann vollständig oder teilweise von der Metallschicht gebildet sein, so dass sie in einer Ausführung aus der Metallschicht besteht. Auch kann eine Ausgestaltung vorsehen, dass die elektrische Sicherungsstruktur aus der Metallschicht und der Schicht aus organischem Material besteht. In einer Ausführung kann die Metallschicht mit mindestens einer der folgenden Schichten kombiniert werden, nämlich der elektrisch dotierten organischen Schicht und der organischen Schicht, die nicht dotiert ist. Die Metallschicht kann die organische Schicht in Teilbereichen oder vollständig bedecken. Hierbei kann in einer Ausführungsform vorgesehen sein, dass die Metallschicht die Schicht aus organischem Material in Abschnitten oder vollständig bedeckt. Die organische Schicht, sei sie elektrisch dotiert oder nicht, kann in Berührungskontakt mit den zugeordneten Elektrodenabschnitten oder den weiteren Elektrodenabschnitten oder ohne Kontakt hiermit gebildet sein. In den verschiedenen Ausführungen kann die Metallschicht nur mit den zugeordneten Elektrodenabschnitten, nur mit dem einen oder den mehreren weiteren Elektrodenabschnitten oder mit beiden in elektrischem Kontakt sein.

Beispielsweise weist die organische Schicht eine Schichtdicke zwischen etwa 10 nm und etwa 50 $\mu m$ auf. Die Metallschicht wird vorzugsweise mit einer Schichtdicke zwischen etwa 10 nm und etwa 10 $\mu m$ gebildet.

Die Schichtdicken sind so gewählt, dass im Falle eines Kurzschlusses im Bereich der Elektrodenabschnitte und dem hiermit einhergehenden, erhöhten Stromfluss die elektrisch dotierte Schicht sich so stark erwärmt, dass sie elektrisch isolierend wird, zum Beispiel indem sie aufschmilzt. Das organische Material der elektrisch dotierten Schicht und die Substratoberfläche, auf welcher das lichtemittierende organische Bauelement gebildet ist, sind so gewählt, dass die elektrisch dotierte Schicht beim Schmelzen entnetzt. Bei der Kombination mit der Metallschicht ist diese dünn genug, um im Fall der Entnetzung aufzureißen. Außerdem ist die Metallschicht so dünn, dass im Falle eines Kurzschlusses eine ausreichend große Wärme durch den ohmschen Widerstand erzeugt wird, um ein Schmelzen der elektrisch dotierten Schicht aus organischem Material zu bewirken. Die Kombination von Metallschicht und elektrisch dotierter Schicht aus organischem Material hat den Vorteil, dass die Temperatur, bei welcher der elektrische Isolierungseffekt durch die Sicherungsstruktur ausgelöst wird, genau gewählt werden kann. Hierdurch lässt sich die elektrische Sicherungsstruktur über die Parameter Schmelztemperatur der elektrisch dotierten Schicht, Dicke der Metallschicht und Design des lichtemittierenden organischen Bauelementes und hieraus folgender Stromfluss auf individuelle Anwendungszwecke anpassen.

Das Schmelzen organischer Materialien erfolgt häufig bereits bei Temperaturen unterhalb von 200°C. Elektrische Sicherungsstrukturen auf Basis von Metallen oder anderen organischen elektrischen Leitern brennen erst bei deutlich höheren Temperaturen durch.

Dünne Filme aus organischem Material können sogar bereits unterhalb ihres Schmelzpunktes einnetzen, was beispielsweise häufig in Verbindung mit flüssigkristallinen Materialien auftritt. In einer bevorzugten Ausbildung ist die organische Schicht der Sicherungsstruktur aus einem flüssigkristallinen Material hergestellt. Ein weiterer Vorteil der Kombination von organischer Schicht, die wahlweise elektrisch dotiert ist, und Metallschicht für die elektrische Sicherungsstruktur besteht darin, dass die Metallschicht vergleichsweise dick gewählt werden kann, da sie sich im Fall des Kurzschlusses nicht so hoch erhitzen muss wie dieses bei einer reinen metallischen Sicherungsstruktur der Fall ist. Hierdurch lassen sich die ohmschen Verluste an der Sicherungsstruktur im normalen Betrieb verringern. Es ist jedoch darauf zu achten, dass die Metallschicht dünn genug ist, um durch eine der Schichten aus organischem Material aufgebrochen zu werden.

Eine bevorzugte Weiterbildung der Erfindung sieht vor, dass die elektrische Sicherungsstruktur eine Schicht aus einem Material ausgewählt aus den folgenden Materialien aufweist: leitfähiges Oxid und leitfähige Keramik.

Bei einer zweckmäßigen Ausgestaltung der Erfindung kann vorgesehen sein, dass die elektrische Sicherungsstruktur als eine Schmelzsicherungsstruktur ausgeführt ist. Beim Ansprechen der elektrischen Sicherungsstruktur aufgrund eines erhöhten Stroms kommt es zum Schmelzen, wodurch eine elektrische Isolierung eintritt.

Beschreibung von Ausführungsbeispielen

Im Folgenden werden Ausführungsbeispiele unter Bezugnahme auf Figuren einer Zeichnung näher erläutert. Hierbei zeigen:

Fig. 1    einen Abschnitt einer Elektrode für ein lichtemittierendes organisches Bauelement, bei der Kammteilelektroden ineinandergreifend angeordnet sind,

Fig. 2    den Abschnitt der Elektrode für das lichtemittierende organische Bauelement nach Fig. 1 mit einem hierüber angeordneten organischen Bereich,

Fig. 3    ein Leuchtbild für ein lichtemittierendes organisches Bauelement mit ineinandergreifenden Kammteilelektroden,

Fig. 4    einen Abschnitt einer Elektrode für ein lichtemittierendes organisches Bauelement, bei der Kammteilelektroden mit trapezförmigen vorstehenden Kammelektrodenabschnitten ineinandergreifen,

Fig. 5    den Abschnitt der Elektrode für das lichtemittierende organische Bauelement nach Fig. 4 mit einem hierüber angeordneten organischen Bereich,

Fig. 6    einen Abschnitt einer Elektrode für ein lichtemittierendes organisches Bauelement, bei der Kammteilelektroden ineinandergreifen, wobei trapezförmige vorstehende Kammelektrodenabschnitte formkomplementär angeordnet sind und über einen Zuleitungsabschnitt an Kammelektrodenverbindungsabschnitte angeschlossen sind,

Fig. 7    den Abschnitt der Elektrode für das lichtemittierende organische Bauelement nach Fig. 6 mit einem hierüber angeordneten organischen Bereich,

Fig. 8    eine schematische Detaildarstellung für den Abschnitt der Elektrode für das lichtemittierende organische Bauelement in Fig. 1 und

Fig. 9    den Abschnitt der Elektrode für das lichtemittierende organische Bauelement mit dem hierüber angeordneten organischen Bereich nach Fig. 7, wobei schematisch den vorstehenden Kammelektrodenabschnitten zugeordnete Sicherungsstrukturen gezeigt sind.

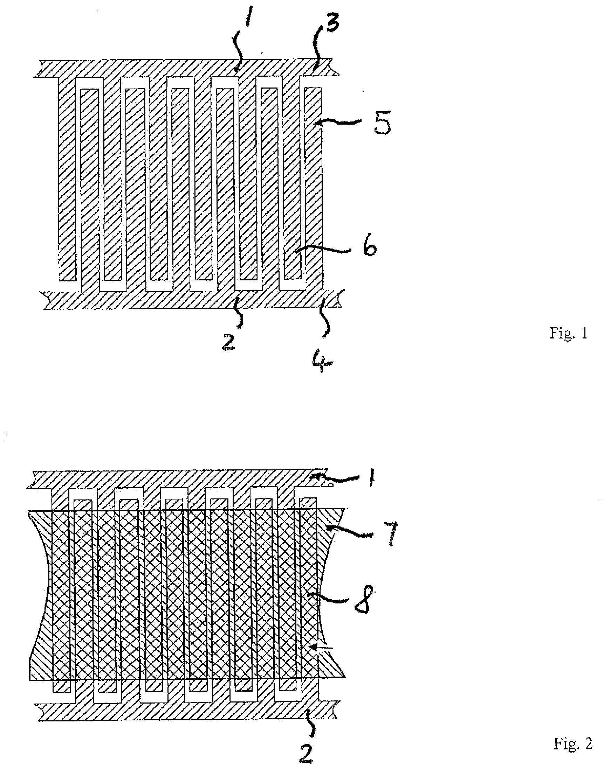

Fig. 1 zeigt einen Abschnitt einer Elektrode für ein lichtemittierendes organisches Bauelement, bei der Kammteilelektroden 1, 2 ineinandergreifend und eine Elektrode des Bauelementes bildend angeordnet sind. Die Kammteilelektroden 1, 2 weisen jeweils einen Kammelektrodenverbindungsabschnitt 3, 4 auf, an dem vorstehende Kammelektrodenabschnitte 5, 6 gebildet sind.

Fig. 2 zeigt den Abschnitt der Elektrode für das lichtemittierende organische Bauelement nach Fig. 1 mit einem hierüber angeordneten organischen Bereich 7, welcher in einem Überlappungsbereich 8 mit den im Eingriff stehenden Kammelektrodenabschnitten 5, 6 überlappt.

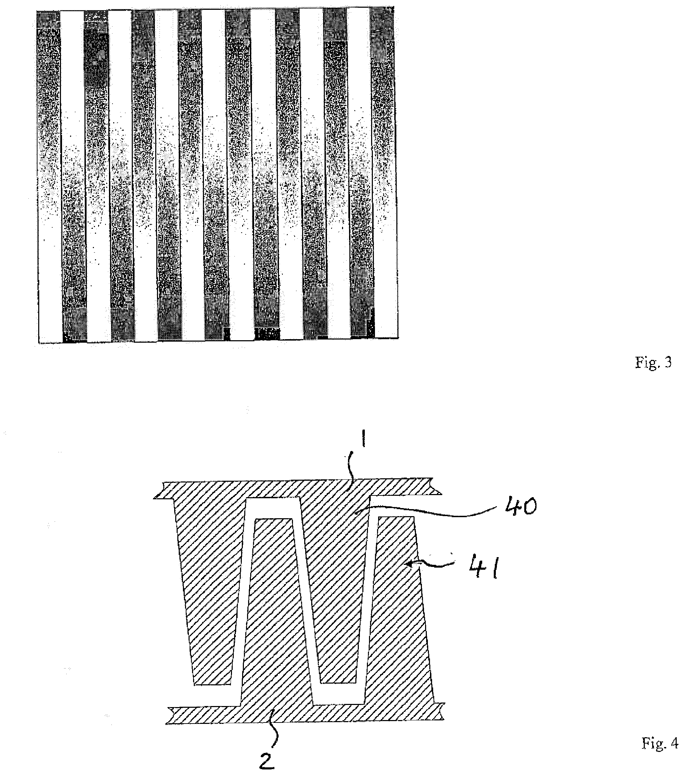

Fig. 3 zeigt ein Leuchtbild für ein lichtemittierendes organisches Bauelement mit ineinandergreifenden Kammteilelektroden.

In einem Beispiel, das nicht Teil der Erfindung ist, wird ein lichtemittierendes organisches Bauelement in Form einer OLED mit einer aktiven Fläche von 20 mm x 20 mm aufgebaut. Eine transparente Grundelektrode, wie schematisch in Fig. 1 dargestellt, wird auf einem Glassubstrat strukturiert. Die einzelnen den vorstehenden Kammelektrodenabschnitten 1, 2 entsprechenden Streifen haben eine Länge von 20 mm und eine Breite von 0.45 mm. Der Abstand zwischen benachbarten Streifen beträgt 0.05 mm. Die transparente Grundelektrode besteht aus 90 nm dickem ITO. Auf die mit dem Kammteilelektroden gebildete Grundelektrode wird ein oranges Licht emittierender Stapel aus organischem Material abgeschieden (vgl. Fig. 2):

1) p-dotierte Lochtransportschicht: 50 nm 4, 4', 4"-tris(N, N-diphenylamino)triphenylamine (Starburst TDATA) dotiert mit Tetrafluoro-Tetracyano-Quinodimethane ($F_4$-TCNQ)

2) löcherseitige Zwischenschicht: 10 nm N,N'-Bis(3-methylphenyl)-N,N'-bis-(phenyl)-benzidine (TPD)

3) orange-rote Emissionsschicht: 20 nm Bis[N-(1-naphthyl)-N-phenyl]benzidine (Alpha-NPD) dotiert mit Iridium (III) bis(2-methyldibenzo [f,h]quinoxaline) (acetylacetonate) (RE076, ADS)

4) elektronenseitige Zwischenschicht: 10 nm Bathophenanthrolin (Bphen)

5) n-dotierte Elektronentransportschicht: 50 nm BPhen dotiert mit Cs

6) Kathode: 100 nm Aluminium

Man beobachtet eine orange Lichtemission durch das Glassubstrat und erkennt mit bloßem Auge, dass das Bauelement in Streifen unterteilt ist, die abwechselnd von beiden Seiten her heller emittieren. Dies ist schematisch und überhöht in Fig. 3 dargestellt. Das derart emittierende Bauelement kann bereits jetzt in dieser Form eingesetzt werden. Die markante Lichtabstrahlung kann als Designelement, zum Beispiel für ein Autorücklicht genutzt werden. Ergänzend kann eine Streufolie auf das so gebildete Bauelement aufgebracht werden, wodurch der Eindruck einer völlig homogenen Lichtabstrahlung erreicht wird. Dies wäre nicht der Fall, wenn alle Streifen aus derselben Richtung kontaktiert wären, also keine im Eingriff stehenden Kammteilelektroden gebildet wären, da dann auch bei Einsatz einer Streufolie noch deutlich der Helligkeitsgradient auszumachen ist.

Fig. 4 zeigt einen Abschnitt einer Elektrode für ein lichtemittierendes organisches Bauelement, bei der Kammteilelektroden mit trapezförmigen vorstehenden Kammelektrodenabschnitte 40, 41 von zwei Kammteilelektroden 1, 2 ineinander greifen.

In der Fig. 4 wird schematisch ein Fall dargestellt, in dem sich die vorstehenden Kammelektrodenabschnitten 40, 41 von der Anschlussstelle (Kammelektrodenverbindungsabschnitt) her verjüngen. Eine solche Geometrie verringert die Ohmschen Verluste und erhöht die Leistungseffizienz des Bauteils. Es kommen Dreiecke, Trapeze, aber auch anders geformte Strukturen in Frage. Alle verjüngen sich in diesen Ausführungsformen aber von der Anschlussstelle her.

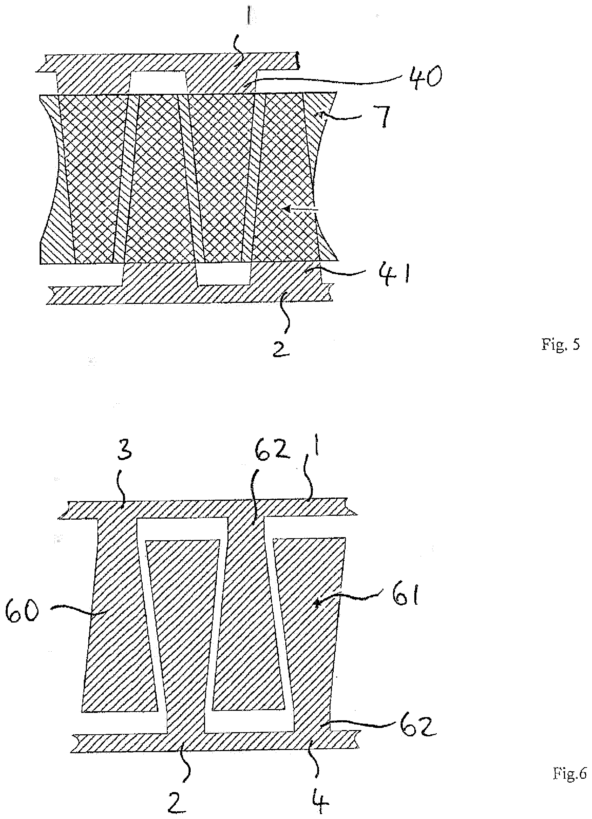

Fig. 5 zeigt den Abschnitt der Elektrode für das lichtemittierende organische Bauelement nach Fig. 4 mit einem hierüber angeordneten organischen Bereich 7.

Fig. 6 zeigt einen Abschnitt einer Elektrode für ein lichtemittierendes organisches Bauelement, bei der Kammteilelektroden ineinandergreifen, wobei trapezförmige vorstehende Kammelektrodenabschnitte 60, 61 formkomplementär angeordnet sind und über einen Zuleitungsabschnitt 62 an Kammelektrodenverbindungsabschnitte 3, 4 angeschlossen sind. Hier ist die schmalste Stelle direkt am Anschluss des jeweiligen vorstehenden Kammelektrodenabschnitts 60, 61. Dadurch erhöhen sich zwar die Ohmschen Verluste, aber die Homogenität der Lichtabstrahlung kann gegebenenfalls verbessert werden.

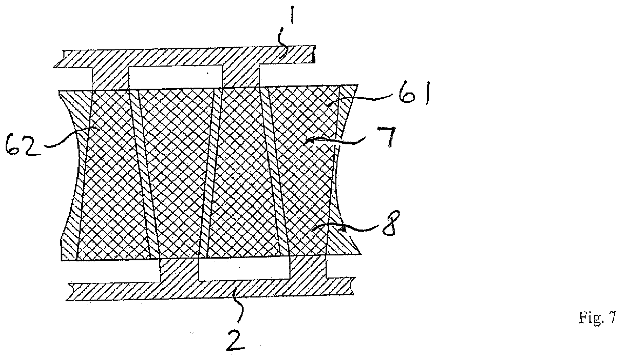

Fig. 7 zeigt den Abschnitt der Elektrode für das lichtemittierende organische Bauelement nach Fig. 6 mit einem hierüber angeordneten organischen Bereich 7.

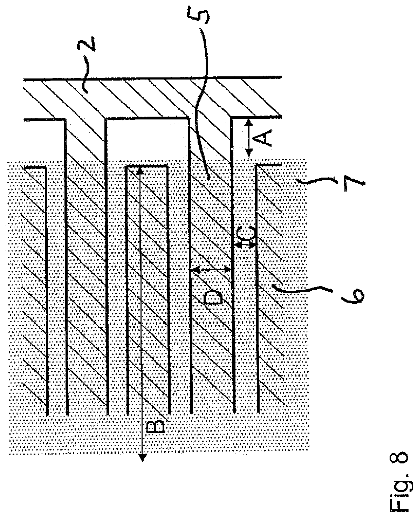

Fig. 8 zeigt eine schematische Detaildarstellung für den Abschnitt der Elektrode für das lichtemittierende organische Bauelement in Fig. 1. Gezeigt sind folgende Parameter: A - Länge des proximalen Endes des vorstehenden Kammelektrodenabschnitts bis zum Rand des organisehen Bereiches, B - Länge des vorstehenden Kammelektrodenabschnitts von dem zugehörigen Kammelektrodenverbindungsabschnitt, C - Abstand zwischen benachbarten Kammelektrodenabschnitten und D - Breites des vorstehenden Kammelektrodenabschnitts.

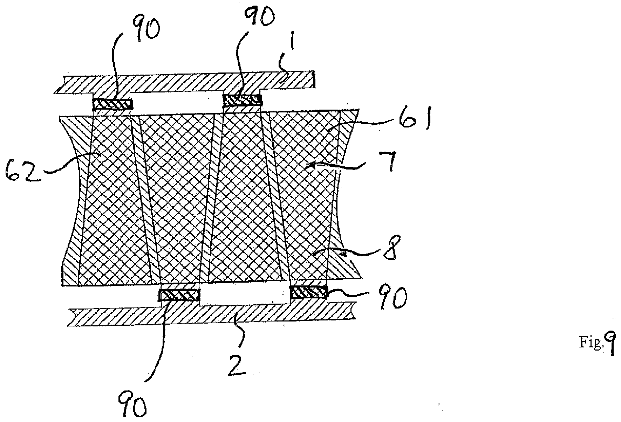

Fig. 9 zeigt den Abschnitt der Elektrode für das lichtemittierende organische Bauelement mit dem hierüber angeordneten organischen Bereich 7 nach Fig. 7, wobei schematisch den vorstehenden Kammelektrodenabschnitten zugeordnete Sicherungsstrukturen 90 gezeigt sind, bei denen es sich beispielsweise um eine jeweilige Schmelzsicherung handelt.

Nachfolgend werden weitere Beispiele, die nicht Teil der Erfindung sind, im Detail erläutert. Hierbei wird insbesondere auch das Zusammenspiel der Parameter aus Fig. 8 näher erörtert.

Auf einem Glassubstrat (nicht dargestellt) werden in einem Beispiel fünf in Reihe geschaltete lichtemittierende organische Bauelemente aufgebracht. Sie bilden zusammen eine Anordnung lichtemittierender organischer Bauelemente.

Zunächst wird eine jeweilige Grundelektrode aus ITO photolithographisch kammartig strukturiert mit vorstehenden Kammelektrodenabschnitte, die an einem Kammelektrodenverbindungsabschnitt gebildet sind. Die Länge B der vorstehenden Kammelektrodenabschnitte ist 20mm; ihre Breite D beträgt jeweils 1mm. Der Schichtwiderstand von ITO beträgt 20 0hm/Quadrat. Die Anzahl paralleler vorstehender Kammelektrodenabschnitte beträgt N = 100; ihr Abstand C ist 20 μm. Auf diese Weise ist zunächst in einem wahlweise getrennt vorgesehenen Herstellungsschritt eine Elektrodenstruktur geschaffen, die ein selbständiges Produkt oder Halbzeug darstellt und dann zur weiteren Verarbeitung, sei es in einem unmittelbar anschließenden Prozess oder im Rahmen einer späteren Prozessierung, für eine Bauelementherstellung genutzt werden kann.

Auf die Elektrodenstruktur wird für die Bauelemente jeweils großflächig ein grünes Licht emittierender organischer Schichtbereich aufgedampft mit einer Stromeffizienz E von 60cd/A. Hierzu wird ein als solcher bekannter organischer Schichtstapel mit dem grünes Licht emittierenden, phosphoreszenten Emittermaterial Ir(ppy)$_3$ verwendet (vgl. He et al., Appl. Phys. Lett., 85(2004)3911)). Eine Helligkeit H von 6000cd/m$^2$ wird bei einer Spannung U von 4V und einer Stromdichte von etwa 10mA/cm$^2$ erreicht. Der Abstand A zwischen den metallischen Deck- oder Topelektroden benachbarter Bauelemente beträgt 3mm.

Entsteht nun in der Mitte einer der vorstehenden Kammelektrodenabschnitte aus ITO ein Kurzschluss, so wird der Strom durch das im Bereich dieses Abschnitts gebildete OLED-Bauelement nur noch durch den Bahnwiderstand der ITO-Zuleitung zu dem Bauelement begrenzt. Der Zuleitungswiderstand beträgt in diesem konkreten Fall: S*(B/2D), also 2000hm. Der Faktor ½ rührt daher, dass der Kurzschluss in der Mitte des Abschnitts liegt.

Die in dem verbleibenden vorstehenden Kammelektrodenabschnitt gebildeten OLED-Bauelemente sind alle noch funktionsfähig. Ihr Gesamtwiderstand beträgt, einschließlich des ITO Bahnwiderstandes, etwa 20Ohm, wie sich leicht aus der Betriebsspannung, der Fläche und der Stromdichte berechnen lässt. Hier wird näherungsweise angenommen, dass die OLED-Bauelemente auf der gesamten Leuchtfläche mit einer homogenen Helligkeit leuchten. Tatsächlich leuchten die Bereiche der OLED-Bauelemente etwas dunkler, in denen aufgrund der Stromzuführung durch die Elektrode ein gewisser Spannungsabfall zum Tragen kommt.

Es ergibt sich, dass knapp 10% des Stroms über den Kurzschluss abfließen und über 90% über die verbleibenden OLED-Bauelemente. Das bedeutet weiterhin, dass die Gesamtanordnung auch bei einem solchen Kurzschluss noch über 90% des Lichtes abgibt. Für die gesamte Anordnung, die aus fünf solchen Bauelementen besteht, ist trotz eines Kurzschlusses immer noch eine Lichtabstrahlung von etwa 98 % zu beobachten. Dies gilt, wenn der Kurzschluss in der Mitte eines vorstehenden Kammelektrodenabschnitts auftritt. Entsteht er noch weiter weg vom Kammelektrodenverbindungsabschnitt wird der ITO-Bahnwiderstand noch größer und damit der Kurzschlussstrom noch einmal um einen Faktor von maximal zwei kleiner. Das heißt, in diesem Fall werden immer noch 99% des Lichtes von der Anordnung von Bauelementen abgegeben.

Die ungünstigste Position für einen Kurzschluss liegt in dem zum Kammelektrodenverbindungsabschnitt benachbarten Bereich der vorstehenden Kammelektrodenabschnitte. Dann wird lediglich ein vorstehender Kammelektrodenabschnitt von 3mm wirksam (entsprechend dem Abstand zwischen Kammelektrodenverbindungsabschnitt und Rand des organischen Bereichs), also ein Zuleitungswiderstand von 60Ohm. Dieses bedeutet, dass das betroffene Bauelement etwa mit 75% Helligkeit weiter leuchtet, die gesamte Anordnung sogar immer noch mit 95%. Es ergibt sich also, dass auch im ungünstigsten Fall eines Kurzschlusses das organische Bauelement noch sehr gut funktionstüchtig ist.

Je geringer das Verhältnis von A zu D ist, desto größer ist die Auswirkung eines Kurzschlusses nahe des benachbarten Kammelektrodenverbindungsabschnitts. Daher ist das Verhältnis A:D zweckmäßig größer als 1, bevorzugt größer als 3 und weiter bevorzugt größer 10. Bei einem Verhältnis A:D von 1 erscheint ein Bauelement mit beispielsweise 100 vorstehenden Kammelektrodenabschnitten im Falle eines Kurzschlusses nahe des Kammelektrodenverbindungsabschnittes durch Verwendung einer Streufolie dem Betrachter bei ausreichendem Abstand noch homogen leuchtend bei Betrachtung mit bloßem Auge, d. h. ohne spezielles Vergrößerungsmittel, zum Beispiel eine Lupe. Sofern das Verhältnis A:D in diesem Falle drei beträgt, wäre ein homogenes Erscheinungsbild auch ohne eine Streufolie erreichbar. Bei einem Verhältnis von 10 könnte mittels einer Streufolie bereits bei einer Streifenzahl von 10 noch eine homogene Helligkeit von einem Betrachter in ausreichendem Abstand wahrgenommen werden.

Befinden sich auf der Anordnung lichtemittierender organischer Bauelemente oder gar auf einem Bauelement gleich mehrere Kurzschlüsse, so bleibt das Bauelement immer noch funktionstüchtig, allerdings reduziert sich die Effizienz mit jedem hinzukommenden Kurzschluss weiter.

Eine Variante, das einzelne Bauelement auch bei Kurzschluss noch effizienter zu gestalten, besteht darin, die vorstehenden Kammelektrodenabschnitte noch dünner zu gestalten. Dann lässt sich das Verhältnis des Stromes durch den Kurzschluss und dem Strom durch den restlichen Bereich des Bauelementes noch weiter verbessern. Allerdings ist es nicht zweckmäßig, die streifenförmigen Elektrodenabschnitte dünner zu machen, als die typische laterale Ausdehnung eines Kurzschlusses. Vorstehende Elektrodenabschnitte dünner als 10μm sind daher eher nicht sinnvoll.

Mit der Erfindung wird es insbesondere ermöglicht, die Produktionsausbeute deutlich zu erhöhen, da Bauelemente auch dann noch verwendet werden können, wenn sich vereinzelte Kurzschlüsse gebildet haben.

Um die optische Erscheinung weiter zu verbessern, kann es vorgesehen sein, Streuelemente in das oder die Bauelemente zu integrieren, wodurch zum einen die nicht leuchtenden Bereiche zwischen den vorstehenden Kammelektrodenabschnitten und zum anderen die durch Kurzschlüsse ausgefallenen Bereiche mittels Streulicht anderer, leuchtender Bereiche überdeckt werden.

Es kann auch vorgesehen sein, nicht die substratseitige Elektrode sondern die Deck- oder Topelektrode zu strukturieren, insbesondere in Streifen. Dies kann beispielsweise mittels Laserbehandlung einer flächigen Deckelektrode erfolgen, welche dann quasi in Streifen geschnitten wird. Hierbei können sogar die unter den zu entfernenden Bereichen der Deckelektrode befindliche Bereiche des organischen Schichtstapels beschädigt werden ohne das hierdurch die Funktionalität des Gesamtbauelementes beeinträchtigt wird, da die so behandelten Bereiche sowieso nicht leuchten.

Die vorgeschlagene Anordnung von Bauelementen, ob nun mit einem Bauelement oder mit mehreren elektrisch in Reihe geschalteten Bauelementen, können auch in Displays eingesetzt werden, um Pixelelemente zu bilden, insbesondere für Displays mit sehr großen Pixelelementen mit einer Größe von mehreren Quadratzentimetern, zum Beispiel bei Stadionleinwänden oder dergleichen. Hier wird aufgrund der Leuchtelemente vermieden, dass im Falle eines Kurzschlusses gleich ein ganzer Pixel ausfällt. Stattdessen wird durch den Betrachter eine nur leicht verringerte Helligkeit eines Pixels, die nicht weiter ins Gewicht fällt, festgestellt.

Besonders gering fällt der Effizienzverlust des Bauelementes aus, wenn die im Bereich der Streifenelektroden gebildeten Bauelemente selber einen geringen ohmschen Widerstand bei der Betriebshelligkeit haben. Dies ist insbesondere bei OLED-Bauelementen mit elektrisch dotierten Bereichen in dem organischen Schichtstapel der Fall.

Besonders homogen ist die Lichtabstrahlung des Bauelementes, wenn die Luminanz-Spannungs-Kennlinie im Bereich der Betriebshelligkeit nicht zu steil ist. Das ist zum Beispiel der Fall, wenn ein Spannungsunterschied von 0,4V einen Helligkeitsunterschied von maximal 40%, bevorzugt von maximal 20% verursacht.

Eine vereinfachte Näherungsformel ergibt für den prozentualen Effizienzverlust V des vorgeschlagenen Bauelementes beim Auftreten eines Kurzschlusses an einer Position, die um eine Strecke K entfernt ist vom Kammelektrodenverbindungsabschnitt des benachbarten Bauelementes, wobei A < K < B gelte:

$$V = U*E / (M*N*B*H*S*K),$$

Hierbei bezeichnen M die Anzahl von verbundenen Bauelementen, H die Betriebshelligkeit und S den Schichtwiderstand von ITO.

Hieraus ergeben sich eine Reihe weiterer Designregeln. Die einzige Größe, die nicht beeinflusst werden kann, ist offenbar K, die Position des Kurzschlusses. Ansonsten gilt, dass die Effizienzverluste im Fall eines Kurzschlusses dann besonders gering ausfallen, wenn

- die Betriebsspannung der OLED-Bauelemente klein ist, zweckmäßig kleiner als 10V, bevorzugt kleiner als 6V und weiter bevorzugt kleiner als 4V;
- die Anzahl der Bauelemente der Anordnung groß ist, zweckmäßig größer als 10, bevorzugt größer als 27 und weiter bevorzugt größer als 55;

- die Anzahl der vorstehenden Kammelektrodenabschnitte groß ist, zweckmäßig größer als 10, bevorzugt größer als 30 und weiter bevorzugt größer als 100;
- die OLED-Bauelemente ausreichend hell betrieben werden, zweckmäßig mit einer Helligkeit von wenigstens 500 cd/m$^2$, bevorzugt mit einer Helligkeit von wenigstens 1000cd/m$^2$ und weiter bevorzugt mit einer Helligkeit von wenigstens 5000cd/m$^2$.

Das Produkt aus S und B wird gesondert betrachtet. Je größer S ist, desto kürzer muss B sein, weil andernfalls die Ohmschen Verluste im Normalbetrieb über dem ITO zu groß werden und damit das Bauelement zu ineffizient wäre. Gute Ergebnisse werden erzielt, wenn das Produkt S*B zwischen 10 und 1000mm*Ohm/Quadrat liegt, bevorzugt zwischen 100 und 1000mm*0hm/Quadrat.

10V ist die ungefähre Betriebsspannung eines einfachen organischen lichtemittierenden Bauelementes vom iii-Typ. 6V entspricht der ungefähren Betriebsspannung eines aufwändigeren organischen lichtemittierenden Bauelementes vom iii-Typ, wie sie als solche im Stand der Technik bekannt sind. 4V ist die ungefähre Betriebsspannung eines organischen lichtemittierenden Bauelementes vom pin-Typ, wie es als solches im Stand der Technik bekannt ist. Darüber hinaus kann 10V, 6V und 4V auch als die ungefähren Betriebsspannungen für einfache, zweifach gestapelte und dreifach gestapelte pin-OLEDs betrachtet werden.

Der Wert einer Helligkeit von 500 cd/m$^2$ stellt einen Helligkeitsgrenzwert dar, ab dem der Einsatz der vorliegenden Erfindung in der Beleuchtungstechnik als besonders zweckmäßig erachtet wird. Sofern ein Beleuchtungsbauteil eine leuchtende Gesamtfläche von 1 Quadratmeter aufweist, entspricht die Lichtleistung bei einer Helligkeit von 500 cd/m$^2$ etwa der halben Lichtleistung einer 100W Glühbirne. Die Helligkeit von 1000 cd/m$^2$ entspricht etwa der Schwelle, bei der ein Beleuchtungselement gerade noch nicht als blendend vom Betrachter wahrgenommen wird, sofern es beispielsweise in einer Beleuchtungssituation als Deckenleuchte eingesetzt wird. 5000 cd/m$^2$ entsprechen einer Helligkeit, die als günstiger Wert für eine Maximierung zwischen Lichtleistung pro leuchtende Fläche des Leuchtbauelementes und Lebensdauer des Leuchtbauelementes erachtet wird. Für eine kommerzielle Optimierung eines Produktes kann es sinnvoll sein, eine Helligkeit in diesem Bereich anzustreben, um eine ausgewogene Balance zwischen den Anschaffungs- und den Herstellungskosten des Bauteils einerseits und der Betriebsleistung und der Lebensdauer andererseits zu schaffen.

Die in der vorstehenden Beschreibung, den Ansprüchen und der Zeichnung offenbarten Merkmale können sowohl einzeln als auch in beliebigen Kombinationen für die Verwirklichung von Ausführungsformen von Bedeutung sein.

**Patentansprüche**

1.  Lichtemittierendes organisches Bauelement, mit

    - einer Elektrode,
    - einer Gegenelektrode und
    - einem zwischen der Elektrode und der Gegenelektrode angeordneten organischen Bereich (7), der über seine flächige Ausdehnung zwischen der Elektrode und der Gegenelektrode mit einer einheitlichen Materialzusammensetzung gebildet ist,

    wobei die Elektrode von untereinander elektrisch kurzgeschlossenen Kammteilelektroden (1, 2) gebildet ist, für die von einem jeweiligen Kammelektrodenverbindungsabschnitt vorstehende Kammelektrodenabschnitte (40, 41; 60, 61) wenigstens in einem Überlappungsbereich mit dem organischen Bereich (7) ineinandergreifend angeordnet sind, **dadurch gekennzeichnet, dass** die vorstehenden Kammelektrodenabschnitte (40, 41; 60, 61) mit nicht parallelen Seitenkanten gebildet sind, wobei die vorstehenden Kammelektrodenabschnitte (40, 41; 60, 61) mit einer Grundflächenform ausgewählt aus der folgenden Gruppe von Grundflächenformen gebildet sind: sich von dem jeweiligen Kammelektrodenverbindungsabschnitt (3, 4) weg verjüngende Grundflächenform und sich von dem jeweiligen Kammelektrodenverbindungsabschnitt (3, 4) weg verbreiternde Grundflächenform.

2.  Bauelement nach Anspruch 1, wobei die vorstehenden Kammelektrodenabschnitte (40, 41; 60, 61) formkomplementär ineinandergreifend angeordnet sind.

3.  Bauelement nach einem der vorangehenden Ansprüche, wobei die vorstehenden Kammelektrodenabschnitte (40, 41; 60, 61) mit einer einheitlichen Grundflächenform gebildet sind.

4.  Bauelement nach einem der vorangehenden Ansprüche, wobei die vorstehenden Kammelektrodenabschnitte (40, 41; 60, 61) mittels des jeweiligen Kammelektrodenverbindungsabschnitts (3, 4) außerhalb des organischen Bereiches (7) untereinander elektrisch kurzgeschlossenen sind.

5.  Bauelement nach einem der vorangehenden Ansprüche, wobei die Gegenelektrode innerhalb der flächigen Ausdehnung des organischen Bereiches und mit einer im Vergleich hierzu kleineren Flächenausdehnung gebildet ist.

6.  Bauelement nach einem der vorangehenden Ansprüche, wobei ein zu dem jeweiligen Kammelektrodenverbindungsabschnitt (3, 4) distales Ende der vorstehenden Kammelektrodenabschnitte (40, 41; 60, 61) mit einem Rand des organischen Bereiches (7) abschließt.

7.  Bauelement nach einem der vorangehenden Ansprüche, wobei die von den Kammteilelektroden (1, 2) gebildete Elektrode eine substratseitige Elektrode ist.

8.  Bauelement nach einem der vorangehenden Ansprüche, wobei in einem Eingriffsbereich ein seitlicher Abstand zwischen benachbarten vorstehenden Kammelektrodenabschnitte (40, 41; 60, 61) weniger als 10 µm beträgt.

9.  Bauelement nach einem der vorangehenden Ansprüche, wobei ein wenigstens mit dem organischen Bereich (7) flächig überlappendes Streuelement gebildet ist.

10. Bauelement nach einem der vorangehenden Ansprüche, wobei den vorstehenden Kammelektrodenabschnitten (40, 41; 60, 61) der Kammteilelektroden (1, 2) jeweils eine elektrische Sicherungsstruktur zugeordnet ist.

11. Anordnung mit einer Reihenschaltung von mehreren lichtemittierenden organischen Bauelementen nach einem der vorangehenden Ansprüche.

**Claims**

1.  A light-emitting organic component, with

    - an electrode,
    - a counter-electrode, and
    - an organic region (7), arranged between the electrode and the counter-electrode, the organic region (7) being formed with a uniform material composition over its planar extent between the electrode and the counter-electrode,

    wherein the electrode is formed by comb sub-electrodes (1, 2) that are electrically short-circuited with one another, for which comb electrode sections (40, 41; 60, 61), protruding from a respective comb electrode connecting section, are arranged in an interlocking manner, at least in a region overlapping with the organic region (7), **characterised in that** the protruding comb electrode sections (40, 41; 60, 61) are formed with non-parallel side edges, wherein the protruding comb electrode sections (40, 41; 60, 61) are formed with a base surface shape selected from the following group of base surface shapes: a base surface shape narrowing from the respective comb electrode connecting section (3, 4), and a base surface shape widening from the respective comb electrode connecting section (3, 4).

2. The component in accordance with claim 1, wherein the protruding comb electrode sections (40, 41; 60, 61) are arranged with complementary shapes in an interlocking manner.

3. The component in accordance with one of the preceding claims, wherein the protruding comb electrode sections (40, 41; 60, 61) are formed with a uniform basic surface shape.

4. The component in accordance with one of the preceding claims, wherein the protruding comb electrode sections (40, 41; 60, 61) are electrically short-circuited with one another outside the organic region (7) by means of the respective comb electrode connecting section (3, 4).

5. The component in accordance with one of the preceding claims, wherein the counter-electrode is formed within the planar extent of the organic region, and with a smaller planar extent in comparison to the latter.

6. The component in accordance with one of the preceding claims, wherein an end of the protruding comb electrode sections (40, 41; 60, 61), distant from the respective comb electrode connecting section (3, 4), terminates at an edge of the organic region (7).

7. The component in accordance with one of the preceding claims, wherein the electrode formed by the comb sub-electrodes (1, 2) is a substrate-side electrode.

8. The component in accordance with one of the preceding claims, wherein in an interlocking region, a lateral distance between adjacent protruding comb electrode sections (40, 41; 60, 61) is less than 10 $\mu$m.

9. The component in accordance with one of the preceding claims, wherein a scattering element is formed that is at least overlapping in a planar manner with the organic region (7).

10. The component in accordance with one of the preceding claims, wherein the protruding comb electrode sections (40, 41; 60, 61) of the comb sub-electrodes (1, 2) are each assigned an electrical fuse structure.

11. An arrangement with a series connection of a plurality of light-emitting organic components in accordance with one of the preceding claims.

**Revendications**

1. Composant organique luminescent, avec

   - une électrode,
   - une contre-électrode et
   - une zone organique (7) disposée entre l'électrode et la contre-électrode, la zone organique (7) étant formée sur son extension en nappe entre l'électrode et la contre-électrode avec une composition de matériau homogène,

   dans lequel l'électrode est formée par des électrodes partielles en peigne (1, 2) court-circuitées électriquement entre elles, pour lesquelles des parties d'électrode en peigne (40, 41 ; 60, 61) en saillie par rapport une partie de liaison d'électrode en peigne respective sont disposées de manière imbriquée au moins dans une zone de chevauchement avec la zone organique (7), **caractérisé en ce que** les parties d'électrode en peigne en saillie (40, 41 ; 60, 61) sont formées par des bords latéraux non parallèles, dans lequel les parties d'électrode en peigne en saillie (40, 41 ; 60, 61) sont formées avec une forme de surface de base sélectionnée dans le groupe suivant de formes de surfaces de base : une forme de surface de base rétrécissant en éloignement de la partie de liaison d'électrode en peigne (3, 4) respective et une forme de surface de base s'élargissant en éloignement de la partie de liaison d'électrode en peigne (3, 4) respective.

2. Composant selon la revendication 1, dans lequel les parties d'électrode en peigne en saillie (40, 41 ; 60, 61) sont disposées de manière imbriquée par complémentarité de formes.

3. Composant selon l'une des revendications précédentes, dans lequel les parties d'électrode en peigne en saillie (40, 41 ; 60, 61) sont formées avec une forme de surface de base homogène.

4. Composant selon l'une des revendications précédentes, dans lequel les parties d'électrode en peigne en saillie (40, 41 ; 60, 61) sont court-circuitées électriquement entre elles au moyen de la partie de liaison d'électrode en peigne (3, 4) respective à l'extérieur de la zone organique (7).

5. Composant selon l'une des revendications précédentes, dans lequel la contre-électrode est formée à l'intérieur de l'extension en nappe de la zone organique et avec une extension surfacique plus petite en comparaison avec celle-ci.

6. Composant selon l'une des revendications précédentes, dans lequel une extrémité distale à la partie de liaison d'électrode en peigne (3, 4) respective des parties d'électrode en peigne en saillie (40, 41 ; 60, 61) se termine avec un bord de la zone organique (7).

7. Composant selon l'une des revendications précédentes, dans lequel l'électrode formée par les électrodes partielles en peigne (1, 2) est une électrode côté substrat.

8. Composant selon l'une des revendications précédentes, dans lequel, dans une zone de mise en prise, un espacement latéral entre des parties d'électrode en peigne en saillie (40, 41 ; 60, 61) voisines est de moins de 10 μm.

9. Composant selon l'une des revendications précédentes, dans lequel un élément de dispersion en chevauchement en nappe avec au moins la zone organique (7) est formé.

10. Composant selon l'une des revendications précédentes, dans lequel on associe aux parties d'électrode en peigne en saillie (40, 41 ; 60, 61) des électrodes partielles en peigne (1, 2) respectivement une structure de coupe-circuit électrique.

11. Agencement avec un couplage en série de plusieurs composants organiques luminescents selon l'une des revendications précédentes.

EP 2 816 628 B1

Fig. 1

Fig. 2

14

Fig. 3

Fig. 4

Fig. 5

Fig.6

Fig. 7

Fig. 8

Fig. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- GB 2392023 A
- DE 102006013408 A1
- US 20060209225 A1
- WO 2008040323 A2

**In der Beschreibung aufgeführte Nicht-Patentliteratur**

- **FORREST et al.** *Adv. Mat.,* 2004, vol. 7, 624
- **HE et al.** *Appl. Phys. Lett.,* 2004, vol. 85, 3911